# EUROPEAN PATENT APPLICATION

(11) **EP 3 770 114 A1**
(43) Date of publication of application: **27.01.2021**
(21) Application number: 20187425.2
(22) Date of filing: 23.07.2020
(51) Int. Cl.: C01B 32/963, C01B 32/956

(54) **METHOD FOR PREPARATION OF POINT DEFECTS (VACANCY) IN SILICON CARBIDE PARTICLES**

(30) Priority: 26.07.2019 HU 1900269
(71) Applicant: Wigner Fizikai Kutatóközpont, 1121 Budapest (HU)
(72) Inventor: Beke, Dávid, 1121 Budapest (HU); Gali, Ádám, 1121 Budapest (HU)
(74) Representative: Krajnyák, András

(57) **Abstract**

In a method for preparation of point defects, so called vacancies in particles point defects are created in a silicon carbide host material and the host material comprising point defects is then transformed into nanoparticles, wherein a cubic silicon carbide matrix (13h) comprising point defects is produced out of 58-90.5 wt% silicon powder (Si), 9-41.5 wt% carbon powder (C) and a 0.5-10 wt% additive (13d). Then, in the step of producing nanoparticles, the silicon carbide matrix (13h) comprising cubic crystal structure point defects is transformed into nanocrystals (13k) via chemical etching. If necessary, the nanocrystals comprising silicon vacancies (13k) can be transformed into nanocrystals comprising divacancies (13m) via heat treatment.

The divacancies produced through the method are located at only a few nanometers from the surface of the silicon carbide matrix (13h). This allows the introduction of room temperature quantum bits into the extremely small nanoparticles, close to the surface of the host material.

## Description

The invention relates to a method for preparation of point defects, so called vacancies in particles according to the introducing part of claim 1.

Present invention generally relates to the production of solid state vacancy quantum bits and single photon sources and, more specifically, to the production of magneto optical vacancies which can be used as magnetometers, thermometers, electrometers, pressure sensors, hyperpolarisers, bioinert fluorophores, and for safe communication based on quantum information, such as the application of silicon carbide divacancy point defect magnetometers, thermometers, electrometers and pressure sensors. They can also be used as a building block for safe quantumcommunication tools and hyperpolarization of molecules.

A number of industrial applications and scientific fields like physics, chemistry and biology can benefit from the creation of a compact, extremely small- and ultrasensitive tool capable of sensing high-fluctuating magnetic, electronic and mechanical deformation spaces and temperature and use this information for high spatial resolution imaging. Industry sectors related to the diagnostics and therapy, and scientific research in chemistry and biology can benefit from manufacturing materials that are capable of hyperpolarizing materials and chemical objects (species), which means that they are able to increase the polarization of nuclear spins in the targeted materials and chemical objects. Telecommunications and internet services can benefit from tools that are capable of stable, high-speed single photon emission.

Atomic scale magneto optical point defect centers are, among others, diamond, silicon carbide, silicon and other materials comprising singular vacancies, divacancies, nitrogen, boron, carbon, silicon, transition metal or other defect centers. Solid state, magneto optical point defect centers at atomic scale, such as divacancies in a silicon carbide lattice, are capable of measuring magnetic fields, electronic fields, mechanical deformations and temperature with excellent sensitivity and allow the manufacturing of small-sized magnetic field, electronic field and pressure sensors or thermometers. In addition, quantum bits working at room temperature, such as divacancies in a silicon carbide lattice, have an outstanding importance in biology and human diagnostics applications as, for example, hyperpolarisation tools of nanoscale sensors and biomolecules. The spin of the point defect electrons can be polarized via the optical pumping of the magneto optical point defect centers. The spin polarization of these electrons can also be transmitted to the surrounding nuclear spins, which will polarize these as well. This nuclear spin polarization can be several orders of magnitude higher than the typical value in a thermal equilibrium. Using this method, the sensitivity of traditional magnetic resonance imaging (MRI) and nuclear magnetic resonance (NMR) technologies can be significantly increased, enabling the perception of the presence of singular molecules. Thereby, solid state point defect quantum bits, such as divacancies in a silicon carbide lattice, can hyperpolarize the silicon and carbon nuclear spins in silicon carbide. Moreover, single photon emitters, such as silicon vacancies in a silicon carbide lattice, have a stable photon emission, whose electron spin can be optically tagged. Silicon carbide silicon vacancy and divacancy sensors will function at room temperature and under atmospheric pressure and can also be used in liquids. Divacancies in a silicon carbide lattice emit light in the so-called second biological window. This makes them an ideal biological fluorophore for examining deep tissues using biological imaging tools.

The applications listed in the paragraphs above require the solid-state point defect quantum bits to be near the surface of the host material. Fluorophores and MRI agents made up of solid-state point defect quantum bits require them to be produced within a nanoscale-sized host material. The production of these solid state point defect quantum bits near the surface or in a nanoscale-sized host material requires us to remove or replace one or more atoms in the lattice of the host material, where the place of the removed atom is called a vacancy. In an ideal case, only the targeted solid state point defect quantum bit or single photon emitter may be produced, as any further unwanted vacancies or other defects, produced in the course of manufacturing, may impair the functioning of the targeted solid state point defect quantum bits or single photon emitters.

Previously, such systems were created by injecting high energy particles (electrons, ions) and grinding. The interaction between the host material and high energy particles creates point defects and other, larger defects.

In a method disclosed in US 20180080145 A1, diamond particles of a particle size up to 250 µm are bound together using an organic polymer binder. The diamond body is irradiated to generate point defects in the diamond particles. The binder is then removed, resulting in separate diamond particles that now comprise point defects.

In a method disclosed US 8,932,554 B2, light-emitting diamond nanoparticles are produced by irradiating them using a high-energy beam, then annealing them in vacuum or in an inert atmosphere at high temperature to form nitrogen vacancy centers.

A common feature of these methods is the need to prepare the host material for irradiation. This is necessary, on the one hand for further operations and, on the other, to create a homogeneous distribution of point defects in the host material. However, these defects, including point defects, usually form randomly. These methods cannot be used to control the types of point defects, nor their location. Some of the unwanted point defects can be removed via heat treatment applied after irradiation, while other defects are randomly created by the heat treatment itself from the defects created during irradiation, as in the case of the nitrogen vacancy centers in diamond in the second method mentioned above.

Nanoparticles can be created out of a host material comprising point defects using a method for grinding such as milling. However, grinding methods might damage the crystal structure of the host material, corrupting the properties of point defect quantum bits and single photon emitters. Due to the random distribution of point defects, they will not be evenly distributed in the nanoparticles. Most nanocrystals do not comprise point defect quantum bits or single photon emitters, and in those nanoparticles that do comprise them, the properties of these quantum bits or single photon emitters are corrupted compared to the properties observed in the quantum bits or single photon emitters in the bulk host material.

The aim of the invention is to provide a solution that can be applied to create point defects without destructive material processing such as irradiation, implantation or grinding, thus avoiding any damage to the crystal structure.

We have realized that in order to produce good-quality nanoparticles comprising point defects, these vacancies can and must be created chemically, during the manufacturing process of the host material, in such a way that they would remain present all the way through any further operations such as the formation of nanoparticles.

Using the appropriate chemical method, a high concentration of point defects can be created, while two-dimensional resist structures can also be created in the bulk material. Point defects will be protected by the resist structure, which will also promote the production of stable quantum bits and single photon emitters in the nanonization process of the bulk material, such as chemical etching used for creating nanosized materials.

The set task was solved using a method according to claim 1. The advantageous options have been listed in dependent claims.

Thus the invention comprises creating cubic crystal structure silicon carbide particles from silicon and carbon, using an additive. During the crystal's growth, the additive reacts with the silicon carbide, chemically creating point defects (vacancies) such as silicon vacancies (Nature Communications, Volume 10, 1954 (2019) and vacancy pairs (Physical review letters, 96: 145501-1-145501-4). In addition, two-dimensional resist structures, such as hexagonal inclusions or stacking faults are also created. Stacking faults function as resists in the process of the pore formation of silicon carbide. This phenomenon is known as no-photon exciton generation chemistry (NPEGEC), which only dissolves cubic silicon carbide, transforming cubic silicon carbide into porous silicon carbide, whose pores are made up of connected nanocrystals (for details see, for example: D. Beke, G. Károlyházy, Z. Czigany, G. Bortel, K. Kamarás, A. Gali: "Harnessing no-photon exciton generation chemistry to engineer semiconductor nanostructures" , Sci. Rep., vol. 7, no. 1, p 10599, Dec. 2017). This leaves two-dimensional hexagonal inclusions and the vacancies located next to them unaffected. The NPEGEC manufacturing method results in producing very small silicon carbide nanoparticles, with an average diameter of 4 nm and a narrow size distribution. Stacking faults resist NPEGEC milling and protect the vacancies near them. The vacancies in these nanoparticles are silicon vacancies, carbon antisite vacancy pairs or divacancies.

In the following, the invention will be presented more in detail, referring to the attached figures where
- Figure 1: shows the change in the concentration of stacking faults as a function of additive concentration
- Figure 2: shows the X-ray diffraction diagram of silicon carbide powder as a function of additive concentration
- Figure 3: shows the fluorescence spectrum of a silicon vacancy as a function of additive concentration
- Figure 4: shows the derived function of the absorption spectrum of the electron spin resonance of the silicon vacancy produced using an additive
- Figure 5: demonstrates the properties of the silicon carbide powder comprising a vacancy as a function of reaction time
- Figure 6: shows the fluorescence spectrum of the tautomer form of silicon vacancies in silicon carbide nanocrystals as a function of additive concentration
- Figure 7: shows the formation of divacancies by annealing the samples through the fluorescence signal of the vacancy as a function of annealing time.
- Figure 8: shows the magnetic resonance spectrum of optically detected divacancies
- Figure 9: shows the size distribution of nanocrystals comprising vacancies
- Figure 10: marks the change in intensity during luminescence heat treatment
- Figure 11: shows the formation of divacancies during annealing at different temperatures
- Figure 12: shows analysis method of vacancy production
- Figure 13: shows three main phases of the production of silicon carbide nanocrystals comprising divacancies

The method according to the invention will be presented through a non-limiting example. Silicon is used as host material, and 14 g Si silicon powder, 6 g C carbon powder and 5.0 wt% aluminum additive 13d are mixed to synthesize silicon carbide. The mixture is heated up in 3 minutes to a temperature of 1250 °C in an induction furnace by using a graphite crucible, then kept at a stable temperature for 5 minutes.

The process can also be carried out at a higher temperature. At the end of the reaction time, heat transmission is interrupted. The reaction produces cubic silicon carbide, with hexagonal inclusions and silicon vacancies 13f. A short reaction time is set in order to prevent the unwanted heat treatment of the silicon vacancies 13f and other defects.

In our experience, the quantity of the additive 13d can be changed between 0.5-10 wt%. Si:C proportions of 0.8:1.2-1.2:0.8 do not significantly change the quality of the product of the reaction. The heat-up time within the range of 3 to 12 minutes again does not significantly change the quality of a silicon carbide matrixl3h.

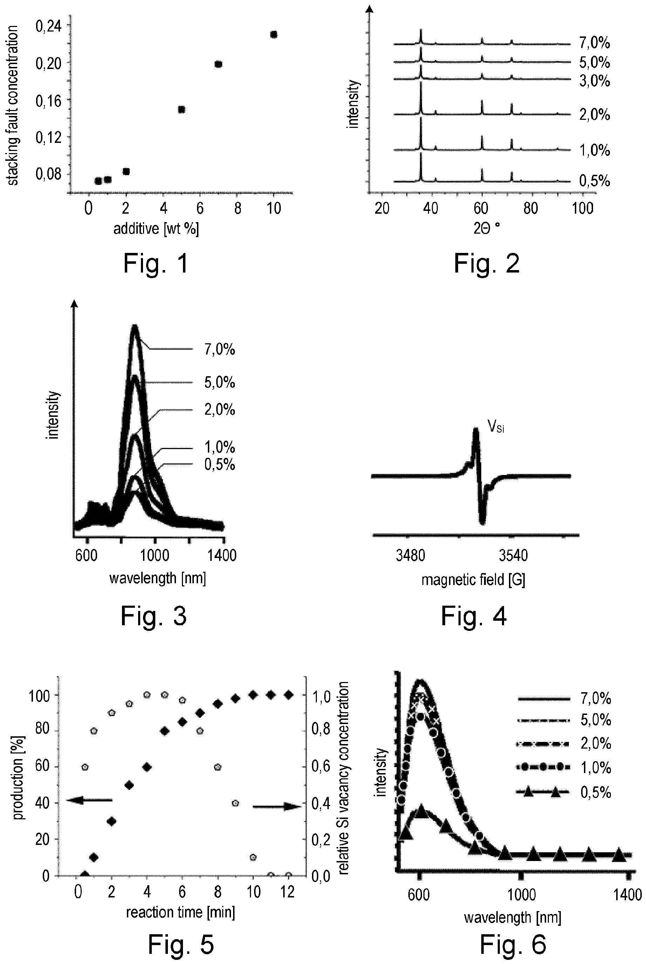

Using an additive 13d quantity of 0.5-10 wt%, the concentration of the hexagonal inclusions and the silicon vacancies 13f also varies proportionately. These measured relationships are depicted on Figures 1-4.

Figure 1 shows the change in stacking fault concentration depending on the amount of the additive 13d. It can be observed here that as the amount of the additive 13d is raised, the amount of the stacking faults rises proportionately, which can be measured by, for example, known X-ray diffraction peaks.

Figure 2 shows X-ray diffraction intensity diagrams of different additive 13d concentration levels of 0.5%, 1.0%, 2.0%, 3.0%, 5.0%, and 7.0% (from bottom to top), as a function of an angle 2θ. Stacking faults are created by the additive 13d, appearing as a shoulder at 34° in the diffractograms. However, the cubic silicon carbide (SiC) matrix structure does not change.

Figure 3 depicts the fluorescence spectrum of the silicon vacancies 13f in the silicon carbide powder comprising 0.5%, 1.0%, 2.0%, 3.0%, 5.0%, 7.0% additive 13d concentrations, depending on the wavelength. It can also be observed that by increasing the concentration of the additive 13d, the concentration of the silicon vacancies 13f increases proportionately. The presence and the concentration of the silicon vacancies 13f can be measured using known fotoluminescence measurement or electron spin resonance measurement methods (see Figure 4).

Figure 4 shows the derived intensity of the absorption spectrum of the electron spin resonance. Mathematically, this can be described as dl/dB, where I is the intensity of the electron spin resonance absorption while B is the magnetic field found on the abscissa. The intensity of photoluminescence is proportional to the concentration of the silicon vacancies 13f. An increase in the concentration of the silicon vacancies 13f results in an increase of photoluminescence intensity. A longer reaction time increases the production of SiC but beyond a certain point (in the concrete example this point is at 6 minutes) it lowers the defect concentration. Production is defined by the ratio of the produced silicon carbide and the total measured amount of carbon and silicon. Relative vacancy concentration can be determined, for example, on the basis of the intensity of the vacancy's emission spectrum or the intensity of the spectrum of the electron spin resonance, as is shown on Figure 5. In the case of 5 wt% aluminum additive 13d, the vacancy concentration reaches its maximum after 4-6 minutes of heat treatment, at which point production changes between 50-80%. Any further production will result in a significant decrease in vacancy concentration. The produced silicon carbide powder is then transformed into nanocrystals, using the NPEGEC method referenced above.

The resulting nanometer scale silicon carbide particles comprise vacancies in a quantity that is proportional to the additive concentration. A significant portion of the nanocrystals form in the vicinity of the two-dimensional resist structure produced by the additive. Therefore, the stacking fault, i.e., the concentration of the resist, has a significant influence on the amount of nanocrystals. As the amount of the resist is increased, the number of nanoparticles comprising vacancies also increases. The change in vacancy concentration can be determined, for example, through the photoluminescence measurement of 4-6 nm diameter silicon carbide nanocrystals. The intensity of the vacancy's photoluminescence spectrum is proportional to the vacancy concentration. The different lines on Figure 6 show the silicon vacancy 13f electron spin resonance spectrums produced using different amounts of additive 13d. Electron spin resonance is a frequently used method for detecting point defects with an electron spin. The spectrum can be interpreted as the presence of pure silicon vacancies 13f (Vₛᵢ). The degree of the so-called zero field splitting demonstrates that the silicon vacancy 13f is located near the stacking fault. Although aluminum has been nominated as additive 13d, the procedure can successfully be carried out using other additives such as boron or polytetrafluoroethylene (PTFE) as well.

In an advantageous and pragmatic additional development of the method according to the invention, the resulting nanoparticles undergo heat treatment, transforming the pairs of silicon vacancies 13f and carbon antisite vacancies into divacancies. This produces silicon carbide nanoparticles in which the divacancies are only a few nanometers away from the surface of the silicon carbide host material.

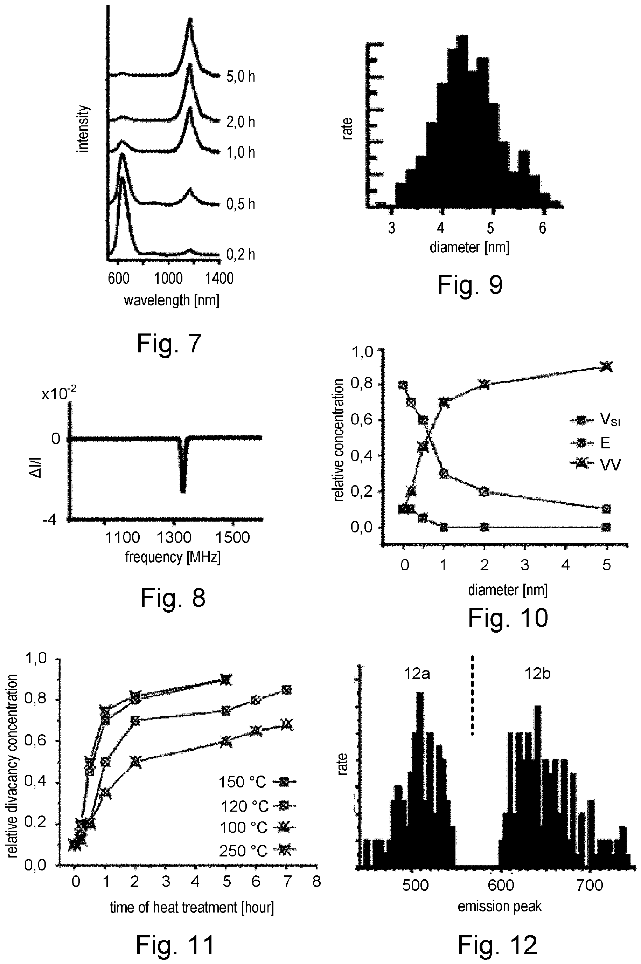

In order to do this, nanosized silicon carbide particles comprising different vacancies are heat treated at a temperature within the range of 60-250 °C, for example, 230 °C, for a time of 0.5-5 hours, 5 hours in our example, thus producing nanosized silicon carbide particles that mostly comprise divacancies. The transformation of the silicon vacancies 13f into divacancies can be followed through the applied heat treatment in nanocrystals, for example, by following the change in the intensity of the photoemissions of the vacancies, as the photoemission is proportional to the number of vacancies. This is shown in Figure 7, where the curves that belong to longer and longer heat treatment times have been plotted above each other to facilitate recognition. As a result of heat treatment, the silicon vacancies 13f and their tautomer forms emitting at a peak of around 620 nm transform into divacancies emitting at a peak of around 1200 nm, resulting in a decrease in the intensity of the silicon vacancies 13f. At the same time, the intensity of divacancy emission increases. The divacancies produced are point defects through which room temperature, optically detected magnetic resonance can be measured. This is shown on Figure 8, where ΔI marks the change of fluorescence intensity (I) due to microwave excitation indicated in MHz units. Optical examination does not provide information on the size distribution of the examined nanocrystals. However, using an atomic force microscope used for measuring the size distribution of nanocrystals comprising vacancies, the measured size of the produced nanocrystals fell in the range of 3-6 nm, their average diameter being 4.5 nm. This distribution is marked on Figure 9. Figure 10 shows the change in the intensity of the luminescence shown on Figure 7 during heat treatment carried out at 150 °C. VV marks the divacancies, (i.e. two contiguous vacancies), V_{Si} marks the Si-vacancies while E marks their tautomer forms. The structure of the latter is called carbon antisite vacancy, whose photoluminescence spectrum is referred to as an E-center in the literature. The intensity of the emission measured is proportional to the concentration. The change in vacancy concentration shows that silicon vacancies 13f transform into divacancies under heat treatment. The formation of divacancies occurs in the 60-250 °C temperature range mentioned earlier, although higher temperatures can also be applied. As Figure 11 shows, raising the temperature from 100 °C to 150 °C accelerates the formation of divacancies and increases the divacancy concentration. Raising the temperature to 200 °C no longer increases the divacancy concentration but the speed of the transformation continues to increase as the temperature is raised.

The 4-6 nm particles obtained by the end of the procedure comprise 0.05-63% divacancies. The degree of vacancy excitation is determined as the ratio of the number of particles comprising vacancies and the total number of particles. One way of determining the degree of vacancy excitation is to examine the emission spectrum of single particles, as nanocrystals comprising vacancies have a different emission spectrum from ones that do not comprise these. A below-600 nm emission peak 12a originates from centers without vacancies, while an above-600 nm emission peak 12b originates from nanocrystals that do comprise vacancies. In the course of a 150 °C degree, 2-hour-long heat treatment, the degree of vacancy excitation calculated from the frequency of maximum values is 63%.

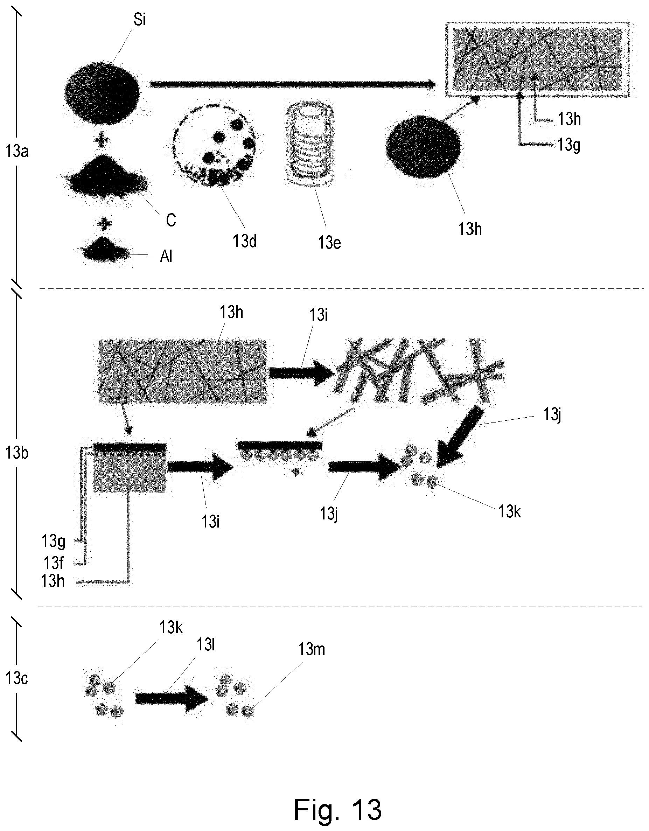

Figure 13 shows the three main phases of the production of silicon carbide nanocrystals comprising divacancies. In a phase 13a Si silicon powder, C carbon powder and, in the current example, aluminum additive 13d are mixed together and heated to at least 1250 °C, producing silicon vacancies 13f and a cubic silicon carbide matrix 13h comprising hexagonal indentions 13g.

The created silicon carbide matrix 13h is then transformed in a phase 13b into nanocrystals 13k comprising silicon carbide vacancies 13f using milling 13i and mechanical impacting 13j (e.g. ultrasound bath) described in the NPEGEC procedure referenced earlier. The silicon carbide matrix 13h, which has become porous, will be broken down in the ultrasound bath. This allows the small particles cohered after the milling to separate. The produced nanocrystals 13k mostly comprise silicon vacancies 13f in one of their tautomer forms. In a phase 13c nanocrystals 13k undergo a heat treatment 131 at 80-250 °C, transforming them into divacancies. This produces stable divacancy quantum bits in the tiny silicon carbide nanocrystals 13m, close to the surface of the silicon carbide crystals.

## Claims

1. Method for preparation of point defects (vacancies) in particles
in which point defects are created in a host material and
nanoparticles are produced from the host material comprising point defects
***wherein***
in the step of creating point defects, silicon carbide is used as host material
where a silicon carbide matrix (13h), also comprising cubic crystal structure and point defects, is produced out of 58-90.5 wt% silicon powder (Si), 9-41.5 wt% carbon powder (C) and a 0.5-10 wt% additive (13d),
in the step of producing nanoparticles, the silicon carbide matrix (13h) also comprising cubic crystal structure and point defects is transformed into nanocrystals (13k) via chemical etching.

2. The method according to claim 1, wherein a mixture consisting of 14 g silicon powder (Si), 6 g carbon powder (C) and 1.1 g aluminum additive (13d) is used for producing the silicon carbide matrix (13h).

3. The method according to claim 2, wherein a material chosen from the group of aluminum, boron and polytetrafluoroethylene is used as an additive (13d).

4. The method according to claim 3, wherein an additive (13d) of at least 0.5 wt% is used.

5. The method according to any of claims 1-4, wherein a cubic silicon carbide matrix (13h) comprising hexagonal inclusions and silicon vacancies (13f) is produced by heating the mixture up to a temperature above 1250 °C and keeping it at said temperature.

6. The method according to claim 5, wherein the mixture is heated up to the required temperature within 3 to 12 minutes.

7. The method according to any of claims 1-6, wherein the silicon carbide nanocrystals (13k) comprising silicon vacancies are transformed into silicon carbide nanocrystals comprising divacancies (13m) via heat treatment.

8. The method according to claim 7, wherein the temperature range of the heat treatment is between 60-250 °C.

9. The method according to claim 7, wherein heat treatment is carried out in a range of 0.5 to 5 hours.
